# EUROPÄISCHE PATENTANMELDUNG

(11) **EP 0 952 601 A2**
(43) Veröffentlichungstag der Anmeldung: **27.10.1999**
(21) Anmeldenummer: 99107026.9
(22) Anmeldetag: 09.04.1999
(51) Int. Cl.: H01H 71/32

(54) **Schutzschaltgerät**

(30) Priorität: 22.04.1998 DE 19818043
(71) Anmelder: SIEMENS AKTIENGESELLSCHAFT, 80333 München (DE)
(72) Erfinder: Schmid, Reinhard, Dipl.-Ing., 93051 Regensburg (DE)

(57) **Zusammenfassung**

Um bei einem Schutzschaltgerät, insbesondere bei einem FI-Schutzschalter, mit einer Auslösevorrichtung (1) mit einem zwischen zwei Polschenkeln (2,3) angeordneten und einen Anker (5) gegen die Kraft einer in Auslöserichtung (A) wirkenden Abzugsfeder (6) haltenden Magnet (4) die Zuverlässigkeit durch eine sichere Überprüfung der Auslösevorrichtung (1) zu erhöhen, ist erfindungsgemäß der Anker (5) mit einem Antrieb (13) gekoppelt, der den Anker (5) in eine senkrecht zur Auslöserichtung (A) verlaufende Antriebsrichtung (B) bewegt.

## Beschreibung

Die Erfindung bezieht sich auf ein Schutzschaltgerät, insbesondere auf einen Fehlerstrom-Schutzschalter, mit einer Auslösevorrichtung mit einem zwischen zwei Polschenkeln angeordneten Magnet, der einen den Polflächen der Polschenkel gegenüberliegenden Anker gegen die Kraft einer in Auslöserichtung wirkenden Abzugsfeder hält.

Ein Fehlerstrom-Schutzschaltgerät (FI-Schutzschalter) dient zur Sicherstellung des Schutzes gegen einen gefährlichen Körperstrom in einer elektrischen Anlage. Dies ist beispielsweise dann der Fall, wenn eine Person ein spannungsführendes Teil einer elektrischen Anlage berührt. Der Fehlerstrom fließt dann über die Person als Körperstrom gegen Erde ab. Der zum Schutz gegen gefährliche Körperströme eingesetzte FI-Schutzschalter trennt bei Überschreiten des sogenannten Bemessungsfehlerstromes sicher und schnell die betroffenen Stromkreise vom Netz.

Der Aufbau eines Fehlerstrom-Schutzschalters ist beispielsweise aus 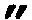 etz", Band 110 (1989), Heft 12, Seiten 580 bis 584, bekannt. Dort sind insbesondere in den Bildern 2 und 4 Prinzipschaltbilder und Funktionsprinzipien eines Fehlerstrom-Schutzschalters bzw. einer diesem zugeordneten Auslösevorrichtung dargestellt. Der Fehlerstrom-Schutzschalter entnimmt die zur Auslösung notwendige Energie netzspannungsunabhängig aus dem Fehlerstrom selbst, während ein sogenannter Differenzstrom- oder DI-Schutzschalter die zum Auslösevorgang erforderliche elektrische Hilfsenergie aus dem Netz entnimmt.

Von einem Fehlerstrom-Schutzschalter wird ein hohes Maß an Sicherheit und Zuverlässigkeit gefordert. Obwohl derartige Schutzschaltgeräte durch kontinuierliche Weiterentwicklung bereits einen sehr hohen Stand hinsichtlich der Zuverlässigkeit deren Funktion erreicht haben, werden dennoch - beispielsweise aufgrund eines unsachgemäßen, ungekapselten Einsatzes von FI-Schutzschaltern in aggressiver Umgebung mit hohem Schadgasgehalt - Fehlfunktionen, insbesondere durch ein Versagen der Auslösevorrichtung, festgestellt.

Um die Zuverlässigkeit der Auslösevorrichtung festzustellen, besteht die Möglichkeit, auf die Auslösespule der Auslösevorrichtung (Auslöserelais) ein Prüfimpuls zu geben und die Reaktion des Systems zu überprüfen. Eine dabei verursachte 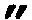 Mikroabhebung" des Ankers oder Ankerplättchens bewirkt eine Vergrößerung des magnetischen Luftspaltes zwischen dem Ankerplättchen und den Polflächen der Magnet- oder Polschenkel. Dies führt in unerwünschter Weise zu einer zumindest kurzzeitigen Reduzierung des Auslösestroms sowie zur Verringerung der gewünschten oder geforderten Fehlauslöse- und Erschütterungsfestigkeit.

Der Erfindung liegt daher die Aufgabe zugrunde, ein Schutzschaltgerät, insbesondere einen Fehlerstrom-Schutzschalter, anzugeben, dessen Zuverlässigkeit im Sinne einer hohen Betriebssicherheit durch eine sichere und reproduzierbare Überprüfung und Überwachung der Auslösevorrichtung gewährleistet ist.

Diese Aufgabe wird erfindungsgemäß gelöst durch die Merkmale des Anspruches 1. Dazu ist dem Schutzschaltgerät ein mit dem Anker dessen Auslösevorrichtung gekoppelter Antrieb zur Bewegung des Ankers in einer Ebene senkrecht zur Auslöserichtung zugeordnet.

Mittels des Antriebs wird der Anker senkrecht zu seiner normalen Arbeitsbewegung, d.h. parallel zu den Polflächen, bewegt. Dabei kann die Bewegung sowohl translatorisch als auch rotatorisch erfolgen. Die Prüfbewegung des Ankers erfolgt zweckmäßigerweise sowohl in Antriebsrichtung als auch entgegen der Antriebsrichtung. Dabei wird diese Prüfbewegung vorzugsweise in konstanten Zeitabständen, z.B. alle 12 Stunden, mechanisch durchgeführt und elektromechanisch, elektrisch oder elektronisch überwacht. Dazu ist dem Antrieb zweckmäßigerweise eine erste Meßeinrichtung für den bei der Bewegung des Ankers zurückgelegten Prüfweg zugeordnet. Des weiteren ist dem Antrieb vorteilhafterweise eine zweite Meßeinrichtung für die zur Bewegung des Ankers aufgewendete Kraft zugeordnet.

Ist in zweckmäßiger Ausgestaltung der Anker über einen mit diesem gelenkig verbundenen Ankerhalter mit der Abzugsfeder verbunden, so ist der Antrieb an den Ankerhalter angekoppelt. Unabhängig von der Ankopplung des Antriebs direkt oder indirekt über den Ankerhalter an den Anker wird in besonders vorteilhafter Weise durch die Prüfbewegung des Ankers senkrecht zu seiner Arbeitsbewegung keine signifikante Änderung des magnetischen Luftspalts zwischen den Polflächen der Polschenkel und den diesen gegenüberliegenden Ankerflächen erzeugt. Dadurch ist auch eine kurzzeitige Reduzierung der magnetischen Haltekraft sicher verhindert, so daß auch ein kurzzeitiger Abfall des Auslösestroms und eine Zunahme der Fehlauslöseund Erschütterungsempfindlichkeit während eines Prüfvorgangs vermieden sind.

Das Ergebnis jeder Prüfbewegung des Ankers hinsichtlich des Prüfweges und der Prüfkraft wird zweckmäßigerweise an ein übergeordnetes Analyse- und Diagnosesystem zur Auswertung des entsprechenden Prüfvorgangs übermittelt. Dazu ist der Antrieb zweckmäßigerweise an ein Übertragungssystem zur Übermittlung der Prüfbewegung des Ankers angeschlossen. Dabei kann es sich z.B. um ein Informationsübertragungssystem nach Art des 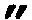 European Installation Bus" (EIB) handeln. Über dieses Übertragungssystem wird regelmäßig die Prüfbewegung des Ankers gemeldet und dokumentiert.

Der Antrieb dient zur Umwandlung eines elektrischen, mechanischen oder pneumatischen Eingangssignals in ein die aufzuwendende Prüfkraft und den zurückgelegten Prüfweg charakterisierendes Ausgangssignal. Dazu ist der Antrieb beispielsweise ein Elektromagnet, ein Pneumatikzylinder, ein Memorie-Metall od.dgl.

In zweckmäßiger Weiterbildung wird das vom Antrieb erzeugte Ausgangssignal über einen von den übrigen Baugruppen des Schutzschaltgerätes unabhängigen Signalpfad an einen Aktor, vorzugsweise an einen Arbeitsstromauslöser, geführt. Der Aktor wiederum kann derart mit dem Schaltschloß des Schutzschaltgerätes gekoppelt sein, daß dieses im Anschluß an eine Auslösung durch den Aktor für eine Wiedereinschaltung blockiert ist.

Die mit der Erfindung erzielten Vorteile bestehen insbesondere darin, daß durch eine translatorische oder rotatorische Prüfbewegung des Ankers einer Auslösevorrichtung eines Schutzschaltgerätes quer zur Auslöserichtung ein beispielsweise durch Schadgase verursachtes Festkorrodieren des Ankers auf den Polflächen sicher verhindert oder zumindest zuverlässig detektierbar ist. Des weiteren ist auch ein Festkleben des Ankers auf den Polflächen sicher vermieden, wenn beispielsweise klebrige oder zur Verharzung führende Substanzen, beispielsweise Öl, in das Innere der Auslösevorrichtung eingedrungen sind. Ferner ist durch die senkrecht zur Auslöserichtung der Auslösevorrichtung erfolgende Prüfbewegung mittels eines entsprechenden Antriebs sowohl in Antriebsrichtung als auch entgegen der Antriebsrichtung eine Reduzierung der magnetischen Haltekraft und der damit verbundene Nachteil einer Verringerung des Auslösefehlerstroms sicher vermieden. Die Fehlauslösefestigkeit sowie die Erschütterungsfestigkeit des Schutzschaltgerätes bleibt somit auch während der Prüfung der Auslösevorrichtung erhalten.

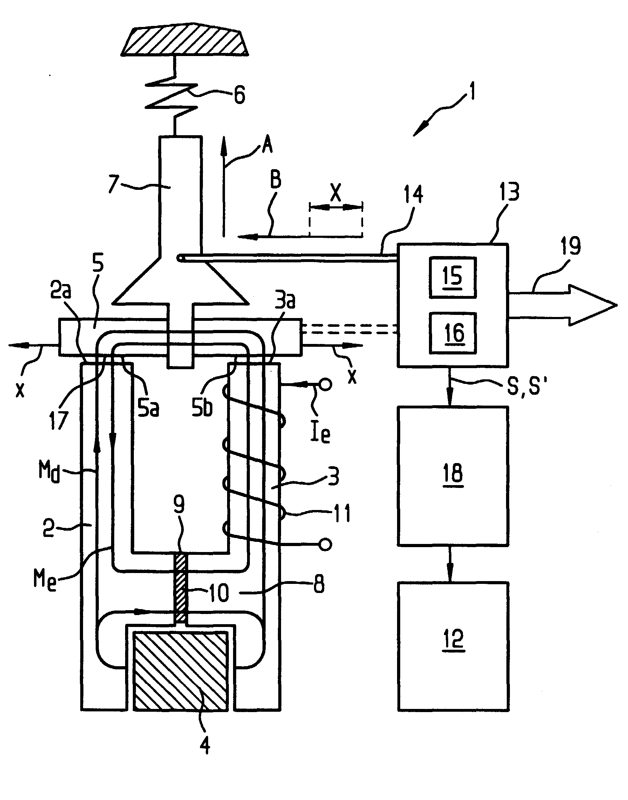

Nachfolgend wird ein Ausführungsbeispiel der Erfindung anhand einer Zeichnung erläutert. Darin zeigt die einzige Figur schematisch eine Auslösevorrichtung eines Schutzschaltgerätes mit einer Prüfeinrichtung.

Die Figur zeigt in schematischer Darstellung eine Auslösevorrichtung 1 in Form eines Auslöserelais oder Haltemagnetauslösers eines FI-Schutzschaltgerätes. Die Auslösevorrichtung 1 umfaßt einen von zwei Polschenkeln 2 und 3 eingeschlossenen Dauermagnet 4, der einen den Polflächen 2a und 3a der Polschenkel 2 bzw. 3 gegenüberliegenden Anker 5 gegen die Kraft einer in Auslöserichtung A wirkenden Abzugsfeder 6 hält. Dazu ist der Anker 5 im Ausführungsbeispiel an einen mit der Abzugsfeder 6 verbundenen Ankerhalter 7 angelenkt.

Im Bereich des Dauermagneten 4 sind die beiden Polschenkel 2 und 3 unter Bildung eines magnetischen Nebenschlusses 8 nahe aneinander angeordnet. Der Magnetfluß M_{d} des Dauermagneten 4 wird über den diesen überbrückenden Nebenschluß 8 geführt. Dadurch ist ein Ab- oder Ummagnetisieren des Dauermagneten 4 vermieden. Hierzu ist zusätzlich in einen Nebenschlußluftspalt 9 zwischen den beiden Polschenkeln 2 und 3 eine unmagnetische Folie 10 eingelegt.

Mindestens einer der Polschenkel 2,3 - im Ausführungsbeispiel der Polschenkel 3 - trägt eine Auslöse- oder Erregerspule 8, die in bekannter Art und Weise zur Erzeugung eines Erregerstroms Iₑ aus einem Fehlerstrom an die Sekundärwicklung eines Summenstromwandlers des Schutzschaltgerätes angeschlossen ist. Der vom Erregerstrom Iₑ erzeugte Magnetfluß Mₑ ist dem vom Dauermagnet 4 erzeugten Magnetfluß M_{d} entgegengerichtet.

Wird die Erregerwicklung 11 vom Erregerstrom Iₑ durchflossen, so schwächt deren Magnetfluß Mₑ den Dauermagnetfluß M_{d} im Anker 5. Dadurch überwiegt die Kraft der Abzugsfeder 6 gegenüber der Kraft des Dauermagneten 4, so daß der Anker 5 über den Ankerhalter 7 abgezogen und dadurch ein Schaltschloß 12 des Schutzschaltgerätes entklinkt wird.

Zur Überprüfung der Funktionsfähigkeit der Auslösevorrichtung 1 ist eine Prüfeinrichtung mit einem Antrieb 13 vorgesehen, der vorzugsweise an den Ankerhalter 7 angekoppelt ist. Hierzu ist der Ankerhalter 7 über eine entsprechende Koppelvorrichtung 14 mit dem Antrieb 13 verbunden. Alternativ kann der Antrieb 13 auch direkt mit dem Anker 4 in Wirkverbindung stehen. Dies ist in der Figur gestrichelt dargestellt.

Während eines Prüfvorgangs, der vorzugsweise in regelmäßigen Zeitintervallen durchgeführt wird, wird mittels des Antriebs 13 der Anker 5 direkt oder über den Ankerhalter 7 zunächst in Antriebsrichtung B bewegt. Dabei verläuft die Antriebsrichtung B senkrecht zur Auslöserichtung A. Im vorliegenden Ausführungsbeispiel verläuft die Auslöserichtung A vertikal, so daß demzufolge die Antriebsrichtung B horizontal verläuft. Die Prüfbewegung erfolgt über eine definierte, vorgebbare Prüfstrecke x. Die den Polflächen 2a und 3a gegenüberliegenden Ankerflächen 5a bzw. 5b werden somit um den Betrag dieser Prüfstrecke oder dieses Prüfweges x in Antriebsrichtung B gegenüber den Polflächen 2a und 3a quer zur Auslöserichtung A verschoben. Anschließend wird der Anker 5 mittels des Antriebs 13 um den gleichen Betrag des Prüfweges x entgegen der Antriebsrichtung B bewegt. Die dabei vom Anker 5 tatsächlich zurückgelegte Strecke wird von einer - beispielsweise dem Antrieb 13 zugeordneten - Meßeinrichtung 15 erfaßt.

Eine weitere - beispielsweise ebenfalls dem Antrieb 13 zugeordnete - Meßeinrichtung 16 erfaßt gleichzeitig die zur Bewegung des Ankers 5 erforderliche Kraft.

Die Prüfbewegung des Ankers 5 senkrecht zur Auslöserichtung oder Arbeitsbewegung A der Auslösevorrichtung 1 bewirkt keine signifikante Änderung des magnetischen Luftspalts 17 zwischen dem Anker 5 und den Polflächen 2a,3a der Polschenkel 2 bzw. 3. Dadurch ist auch ein kurzzeitiger Abfall des Auslösestroms und eine Zunahme der Fehlauslösungs- und Erschütterungsempfindlichkeit sicher vermieden.

Überschreitet die für eine Prüfbewegung des Ankers 5 erforderliche Kraft einen vorgebbaren Höchst- oder Schwellwert, so erzeugt die Meßeinrichtung 16 ein entsprechendes Melde- oder Auslösesignal S. Dieses wird über einen vom üblichen Schutzschaltgerät unabhängigen Signalpfad einem Aktor 18 zugeführt. Der Aktor 18 ist beispielsweise ein Arbeitsstromauslöser, der mit dem Schaltschloß 12 des Schutzschaltgerätes in Wirkverbindung steht. Erhält der Aktor 18 ein entsprechendes Meldesignal S, so bewirkt dieser eine Auslösung des Schaltschlos-ses 12.

Da bei Überschreiten des Schwellwertes für die zur Prüfbewegung des Ankers 5 erforderliche Kraft von einem Festkorrodieren oder Festkleben des Ankers 5 auf den Polflächen 2a,3a ausgegangen werden kann, ist es zweckmäßig, wenn der Aktor 18 das Schaltschloß 12 derart entklinkt, daß ein Wiedereinschalten nicht mehr möglich ist. Eine derartige Blockierung des Schaltschlosses 12 wird zweckmäßigerweise bereits dann bewirkt, wenn der Anker 5 nur über einen Teil des vorgegebenen Prüfweges x bewegbar oder verschiebbar ist. In diesem Fall liefert die Meßeinrichtung 15 ein entsprechendes Melde- oder Auslösesignal S' an den Aktor 18 zur Auslösung und Blockierung des Schaltschlosses 12. Der Antrieb 13 führt dabei bereits bei nur annähernd unbeweglichem Anker 5 dem Aktor 18 ein Auslösesignal S,S' zum Auslösen und Verriegeln des mit diesem gekoppelten Schaltschlosses 12 zu.

Die Prüfbewegung des Ankers 5 kann sowohl translatorisch als auch rotatorisch erfolgen. Bei einer translatorischen Prüfbewegung überragt der Anker 5 zweckmäßigerweise beidseitig die Polschenkel 2 und 3 um jeweils einen etwa dem halben Prüfweg x entsprechenden Betrag. Bei einer rotatorischen Prüfbewegung wird der Anker (Ankerplättchen) 5 um eine in Auslöserichtung A verlaufende Achse mit einem definierten, vorgebbaren Drehwinkel z.B. zunächst im Uhrzeigersinn verdreht. Anschließend erfolgt dann eine Drehung des Ankers 5 entgegen dem Uhrzeigersinn. Dabei wird wiederum die zur Erzeugung der Drehbewegung erforderliche Kraft mittels der Meßeinrichtung 16 erfaßt und mit einem entsprechenden Schwellwert verglichen. Auch wird der dabei zurückgelegte Prüfweg x, beispielsweise durch Messung des Drehwinkels, mittels der Meßeinrichtung 15 erfaßt und durch Vergleich mit einem Schwellwert ausgewertet.

Das Ergebnis jeder einzelnen Überprüfung der Auslösevorrichtung 1 und damit die von den Meßeinrichtungen 15,16 ermittelten Informationen werden über ein Informationsübertragungssystem 19, beispielsweise über einen Datenbus (EIB), an ein übergeordnetes Überwachungssystem gemeldet. Dabei werden einerseits die Informationen hinsichtlich fehlerfreier Prüfbewegungen des Ankers 5 entlang des gesamten Prüfweges x zu Dokumentationszwecken übermittelt. Andererseits werden alle Informationen über ein infolge eines Festkorrodierens oder Festklebens des Ankers 5 an den Polschenkeln 2,3 mittels der Prüfeinrichtung festgestelltes potentielles Versagen der Auslösevorrichtung 1 zum Zwecke einer frühzeitigen Einleitung geeigneter Gegenmaßnahmen übertragen.

## Patentansprüche

1. Schutzschaltgerät, insbesondere Fehlerstrom-Schutzschalter, mit einer Auslösevorrichtung (1) mit einem zwischen zwei Polschenkeln (2,3) angeordneten Magneten (4), der einen den Polflächen (2a,3a) der Polschenkel (2,3) gegenüberliegenden Anker (5) gegen die Kraft einer in Auslöserichtung (A) wirkenden Abzugsfeder (6) hält, **gekennzeichnet durch** einen mit dem Anker (5) gekoppelten Antrieb (13) zur Bewegung des Ankers (5) senkrecht zur Auslöserichtung (A).

2. Schutzschaltgerät nach Anspruch 1, **dadurch gekennzeichnet**, daß eine translatorische Bewegung des Ankers (5) parallel zu den Polflächen (2a,3a) sowohl in Antriebsrichtung (B) als auch entgegen der Antriebsrichtung (B) erfolgt.

3. Schutzschaltgerät nach Anspruch 1, **dadurch gekennzeichnet**, daß eine rotatorische Bewegung des Ankers (5) entlang der Polflächen (2a,3a) erfolgt.

4. Schutzschaltgerät nach einem der Ansprüche 1 bis 3, **dadurch gekennzeichnet**, daß dem Antrieb (5) eine erste Meßeinrichtung (15) für den bei der Bewegung des Ankers (5) zurückgelegten Prüfweg (x) zugeordnet ist.

5. Schutzschaltgerät nach einem der Ansprüche 1 bis 4, **dadurch gekennzeichnet**, daß dem Antrieb (5) eine zweite Meßeinrichtung (16) für die zur Bewegung des Ankers (5) aufgewendete Kraft zugeordnet ist.

6. Schutzschaltgerät nach einem der Ansprüche 1 bis 5, **dadurch gekennzeichnet**, daß der Anker (5) über einen mit diesem gelenkig verbundenen Ankerhalter (7) mit der Abzugsfeder (6) verbunden ist, wobei der Antrieb (13) mit dem Ankerhalter (7) verbunden ist.

7. Schutzschaltgerät nach einem der Ansprüche 1 bis 6, **dadurch gekennzeichnet**, daß in vorgebbaren Zeitintervallen eine Prüfbewegung des Ankers (5) innerhalb eines einstellbaren Prüfweges (x) erfolgt.

8. Schutzschaltgerät nach einem der Ansprüche 1 bis 7, **dadurch gekennzeichnet**, daß der Antrieb (13) an ein Übertragungssystem (19) zur Übermittlung der Prüfbewegung des Ankers (5) angeschlossen ist.

9. Schutzschaltgerät nach einem der Ansprüche 1 bis 8, **dadurch gekennzeichnet**, daß der Antrieb (13) bei zumindest annähernd unbeweglichem Anker (5) einem Aktor (18) ein Auslösesignal (S,S') zum Auslösen und Verriegeln eines mit diesem gekoppelten Schaltschlosses (12) zuführt.

10. Schutzschaltgerät nach Anspruch 9, **dadurch gekennzeichnet**, daß der Aktor (18) ein Arbeitsstromauslöser ist.
